# EUROPEAN PATENT SPECIFICATION

(11) **EP 2 394 300 B1**
(45) Date of publication and mention of the grant of the patent: **15.08.2018**
(21) Application number: 10703518.0
(22) Date of filing: 02.02.2010
(51) Int. Cl.: H01L 25/16

(54) **IMPROVED PACKAGING FOR LED COMBINATIONS**
VERBESSERTE VERPACKUNG VON LEUCHTDIODENKOMBINATIONEN
EMPAQUETAGE AMÉLIORÉ POUR COMBINATIONS DES DIODES ÉLECTROLUMINESCENTES

(30) Priority: 05.02.2009 EP 09152100
(43) Date of publication of application: 14.12.2011
(73) Proprietor: Philips Lighting Holding B.V., 5656 AE Eindhoven (NL)
(72) Inventor: DE SAMBER, Marc, A., NL-5656 AE Eindhoven (NL); EGGINK, Hendrik, J., NL-5656 AE Eindhoven (NL)
(74) Representative: van Eeuwijk, Alexander Henricus Waltherus
(86) International application number: PCT/IB2010/050441
(87) International publication number: WO 2010/089696

(56) References cited:
- WO-A2-2004/100265
- JP-A- 2007 251 120
- US-A1- 2006 243 986
- US-A1- 2007 200 512
- US-A1- 2008 217 633

## Description

### FIELD OF THE INVENTION

The present invention generally relates to a device, a system, a method and a computer program enabling a thermally improved packaging of multiple light emitting diodes (LEDs). In particular, it relates to a device, a system, a method and a computer program enabling a thermally improved packaging of multiple LEDs and an integrated circuit (IC).

### BACKGROUND OF THE INVENTION

When packaging red (R), green (G) and blue (B) LEDs together in a narrow spaced ultra-thin leadless package (UTLP) or other small package (miniaturization is preferred, as this results in a good etendue of a RGB light source), the LEDs will thermally influence each other. This is in particular a problem for the red LED, as this LED type is sensitive to high temperatures. Thus, it would be useful to have a package technology allowing to protect temperature sensitive LEDs in case of a high temperature resulting from e.g. driving LEDs at high current.

When going further along the functional integration roadmap, it might be a wish to include a driver IC into the LED package (called an optical SiP). ICs typically suffer from too high ambient temperatures. If an IC operating at high temperatures is required, then cost goes up dramatically. Hence, in this case it would be useful to have a package technology that allows to operate the LEDs at a high temperature (which may be a result of driving these LEDs at high current) while keeping the IC(s) inside the same package at a low(er) temperature (within their working temperature specifications).

The above also applies in case of packaging LEDs emitting light of the same color, for example when packaging only red LEDs, green LEDs, blue LEDs or LEDs of some other kind such as e.g. direct white conversion LEDs generating white light by using a phosphor material to convert monochromatic light emitted by a blue or ultraviolet LED to broad-spectrum white light. When combining LEDs emitting light of the same color and a driver IC, the LEDs might have the same temperature characteristics but the IC should still be kept at a lower temperature level.

US2006243986 discloses temperature-sensitive (red-emitting) AlGaInP-LEDs surrounded by less temperature-sensitive (blue-green-emitting) GaN-LEDs. Thermal separation between the cool- and hot-LED types is realised by trenches. US2007200512 teaches a plurality of LEDs and a drive circuit mounted on a common substrate.

### SUMMARY OF THE INVENTION

It is an object of the present invention to alleviate at least some of the above described problems.

This object can be achieved by a device according to claim 1, a system according to claim 13, a method according to claim 14 and a computer program according to claim 15.

Accordingly, in a first aspect of the present invention a device is presented. The device can comprise at least one mounting area, a plurality of light emitting diodes respectively mounted on the at least one mounting area and configured to emit light of a specific color, and at least one integrated circuit mounted on the at least one mounting area and configured to drive at least one of the plurality of light emitting diodes. A most temperature sensitive light emitting diode of the plurality of light emitting diodes may be located between less temperature sensitive light emitting diodes of the plurality of light emitting diodes and the at least one integrated circuit. Thus, it can be prevented that the at least one integrated circuit is located close to those light emitting diodes having higher temperature limits and being operated at higher temperatures. Hence, the at least one integrated circuit may be protected and kept at lower temperatures within its working temperature specifications.

In a second aspect of the present invention the plurality of light emitting diodes can be mounted on at least two different sized mounting areas. By mounting light emitting diodes operable at higher temperatures on bigger mounting areas allowing an improved heat dissipation, heat generated by each light emitting diode may be efficiently dissipated. The second aspect can be combined with the first aspect.

In a third aspect of the present invention the plurality of light emitting diodes may be mounted on at least one mounting area separated from at least one mounting area on which the at least one integrated circuit is mounted. Thus, a hot part of the device including the plurality of light emitting diodes can be separated from a cool part of the device including the at least one integrated circuit. Hence, the at least one integrated circuit may be protected from higher temperatures. The third aspect can be combined with any one of the preceding aspects.

In a fourth aspect of the present invention the device may comprise at least one thermal shielding located between the plurality of light emitting diodes and the at least one integrated circuit. This shielding can shield the at least one integrated circuit from heat generated by the light emitting diodes. Thus, the at least one integrated circuit may be protected from the heat. The fourth aspect can be combined with any one of the preceding aspects.

In a fifth aspect of the present invention the device may comprise at least one thermal conductor located between the plurality of light emitting diodes and the at least one integrated circuit and configured to transport heat. The thermal conductor can provide additional heat transport in the device. Therefore, heat may be efficiently dissipated. The fifth aspect can be combined with any one of the preceding aspects.

In a sixth aspect of the present invention the device can comprise at least one thermal shielding located between the most temperature sensitive light emitting diode and at least one of the less temperature sensitive light emitting diodes. In this way, the most temperature sensitive light emitting diode may be protected from heat generated by less temperature sensitive light emitting diodes. Thus, a thermal influence of the latter on the former can be reduced. The sixth aspect may be combined with any one of the preceding aspects.

In a seventh aspect of the present invention the device may comprise at least one thermal shielding located between at least two of the less temperature sensitive light emitting diodes. Thus, a thermal influence of the less temperature sensitive light emitting diodes on each other can be reduced. Hence, these light emitting diodes may be thermally decoupled. The seventh aspect can be combined with any one of the preceding aspects.

In an eighth aspect of the present invention at least one of the at least one mounting area may be asymmetrically shaped in such a manner that a distance between the plurality of light emitting diodes and the at least one integrated circuit is maximized. In this way, the at least one integrated circuit can be located as far from the light emitting diodes as possible. Thus, an influence of heat generated by the light emitting diodes may be reduced. The eighth aspect can be combined with any one of the preceding aspects.

In a ninth aspect of the present invention the device may comprise a structure including at least one material and surrounding the plurality of light emitting diodes and the at least one integrated circuit, wherein the structure can comprise at least two sections having different heat transfer characteristics. Thus, the heat transfer at a certain location may be locally increased or decreased, in dependence on which component of the device is situated at the location. The ninth aspect can be combined with any one of the preceding aspects.

In a tenth aspect of the present invention a cross section of the device may be reduced at least locally. Hence, a heat dissipation to the outside of the device can be improved. The tenth aspect may be combined with any one of the preceding aspects.

In an eleventh aspect of the present invention the device can comprise at least one ring-like structure configured to thermally shield at least one of the plurality of light emitting diodes and/or the at least one integrated circuit. Thus, specific components of the device may be protected from heat generated by other components thereof. The eleventh aspect can be combined with any one of the preceding aspects.

In a twelfth aspect of the present invention the device may comprise at least one ring-shaped heatsink configured to dissipate heat generated by at least one of the plurality of light emitting diodes and/or the at least one integrated circuit. In this way, heat generated by a component of the device can be efficiently dissipated. The twelfth aspect may be combined with any one of the preceding aspects.

In a thirteenth aspect of the present invention a system is presented. The system can comprise a board including thermal dissipation enhancing elements and at least one device according to any one of the preceding aspects. The at least one device may be mounted on the board. Thus, a good thermal transfer from the at least one device to the board and a good overall thermal performance can be achieved.

In a fourteenth aspect of the present invention a method is presented. The method may comprise mounting a plurality of light emitting diodes, respectively configured to emit light of a specific color, on at least one mounting area, and mounting at least one integrated circuit, configured to drive at least one of the plurality of light emitting diodes, on the at least one mounting area. A most temperature sensitive light emitting diode of the plurality of light emitting diodes can be located between less temperature sensitive light emitting diodes of the plurality of light emitting diodes and the at least one integrated circuit. Thus, it may be prevented that the at least one integrated circuit is located close to those light emitting diodes having higher temperature limits and being operated at higher temperatures. Hence, the at least one integrated circuit can be protected and kept at lower temperatures within its working temperature specifications.

In a fifteenth aspect of the present invention a computer program is presented. The computer program may comprise program code means for causing a computer to carry out the steps of a method according to the fourteenth aspect when the computer program is carried out on a computer. Thus, the same advantages as with the method according to the fourteenth aspect can be achieved.

Further advantageous modifications are defined in the dependent claims.

### BRIEF DESCRIPTION OF THE DRAWINGS

These and other aspects of the present invention will be apparent from and elucidated by an embodiment described hereinafter with reference to the accompanying drawings, in which:
Fig. 1 shows a schematic diagram illustrating an arrangement of an exemplary device according to the embodiment;
Fig. 2 shows a schematic top view of the exemplary device according to the embodiment as illustrated in Fig. 1;
Fig. 3 shows a schematic perspective view of the exemplary device according to the embodiment being mounted on a board;
Fig. 4 shows a flowchart illustrating basic steps of an exemplary method according to the embodiment; and
Fig. 5 shows an example of a software-based implementation of the embodiment.

### DETAILED DESCRIPTION OF AN EMBODIMENT

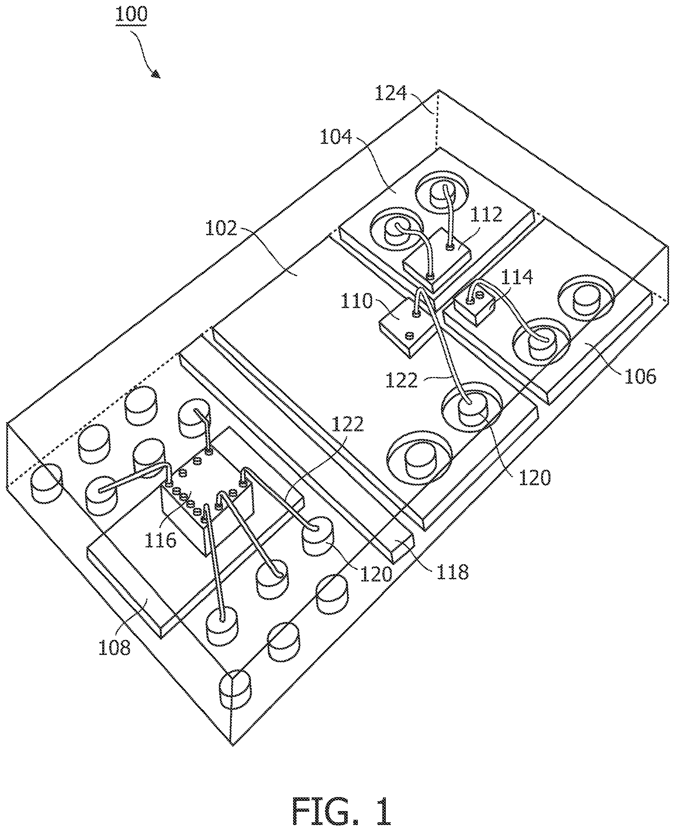

Fig. 1 shows a schematic diagram illustrating an arrangement of an exemplary device 100 according to the embodiment. The device 100 may be some kind of ultra-thin leadless package (UTLP) or other small package. It can comprise a first mounting area 102, a second mounting area 104, a third mounting area 106, and a fourth mounting area 108. Further, it may comprise a red (R) light emitting diode (LED) 110, a green (G) LED 112, a blue (B) LED 114, and an integrated circuit (IC) 116. The IC 116 can be e.g. an application-specific integrated circuit (ASIC), which may comprise a thermal sensor. In addition, the device 100 can comprise a shielding 118, a plurality of contact pads 120, a plurality of connectors 122, and a structure 124 including at least one material such as e.g. a silicone material.

The red LED 110, the green LED 112 and the blue LED 114 may be mounted on the first, second and third mounting areas 102, 104 and 106, respectively. These mounting areas can be called LED die pads. The IC 116 may be mounted on the fourth mounting area 108. This mounting area can be called an IC pad. Each of the LEDs 110, 112, 114 and the IC 116 may be connected to contact pads 120 by means of connectors 122 such as e.g. thin wires. Only part of these components is illustrated in Fig. 1.

While separate mounting areas for each of the LEDs 110, 112, 114 and the IC 116 are shown in Fig. 1, other configurations are possible. For example, two or more of the LEDs 110, 112, 114 can be mounted on a common mounting area. Further, one or more of the LEDs 110, 112, 114 and the IC 116 may be mounted on a common mounting area. In addition, there can be more than three LEDs and/or multiple ICs.

Each of the LEDs 110, 112, 114 may emit light of a specific color. Together they can form a RGB light source. The LEDs 110, 112, 114 may be driven by the IC 116. That is, the IC 116 can control currents used to drive the LEDs 110, 112, 114. There may be multiple ICs, wherein each of these can drive one or more LEDs.

As shown in Fig. 1, the red LED 110 can be located between the green and blue LEDs 112, 114 on the one hand and the IC 116 on the other hand. The red LED 110 is sensitive to high temperatures. That is, the red LED 110 is a most temperature sensitive LED of the plurality of LEDs 110, 112, 114, and the green and blue LEDs 112, 114 are less temperature sensitive LEDs of the plurality of LEDs 110, 112, 114.

If the IC 116 is not some kind of IC operable at high temperatures, it suffers from too high ambient temperatures. By placing the red LED 110 operated at lower temperatures between the other LEDs 112, 114 operated at higher temperatures and the IC 116, the IC 116 may be protected and kept at lower temperatures within its working temperature specifications.

UTLP is already a package that has a good thermal transfer to the board (due to direct attachment of the LEDs to a (large) part of the footprint). However, the above described packaging enables a thermally improved device or package.

Various other measures can be taken to provide further improved packages, i.e. thermally optimize the packaging. For example, die pads, footprints and additional (possibly dummy) pads may be modified/designed, within the design rules of the UTLP packaging technology, in such a way that the thermal shielding between components in the package can be improved. In the following, specific measures are described in more detail.

As shown in Fig. 1, the first, second, third and fourth mounting areas 102, 104, 106, 108, i.e. LED die pads and IC pads, may be asymmetrically shaped such that a distance from each LED to a "sensitive" part is optimized. In this way, a temperature sensitive component such as e.g. the IC 116 can be protected from heat generated by the LEDs 110, 112, 114. Usual designs of semiconductors are straightforward symmetric designs. They do not provide such effect.

As also shown in Fig. 1, certain LED die pads can be made larger than others, in such a way that heat generated at one location is not/less influencing other parts of the device 100. That is, the first mounting area 102 for the most temperature sensitive red LED 110 may be bigger than the second and third mounting areas 104, 106 for the less temperature sensitive green and blue LEDs 112, 114. Thus, the first mounting area 102 can provide an improved heat dissipation in comparison with the second and third mounting areas 104, 106. Hence, the temperature sensitive red LED 110 may be protected and kept at temperatures within its working temperature specifications. That is, footprints can be modified/designed such that a thermal shielding between components of the device 100 may be improved.

Additional pads (that are either un-occupied, or on which a "dummy", shielding die or heat sink are mounted) can be provided, in such a way that heat generated at one location is not/less influencing other parts of the device 100. For example, the shielding 118 may be provided between a hot part of the device 100 comprising the first, second and third mounting areas 102, 104, 106, the red, green and blue LEDs 110, 112, 114 and associated contact pads 120 and connectors 122, and a cool part of the device 100 comprising the fourth mounting area 108, the IC 116 and associated contact pads 120 and connectors 122. The shielding 118 can be e.g. a metal elongated "die" acting as a thermal "wall". It may separate the hot part of the device 100 from the cool part thereof, i.e. "thermally decouple" these parts. Hence, the IC 116 can be protected from too high temperatures. The shielding 118 may also be composed of or comprise some kind of thermal conductor for transporting heat, for example a protruding thermal conductor or dummy die. Such thermal conductor can provide additional heat transport in the device 100, i.e. enable an efficient dissipation of heat. That is, either one or both of a thermal wall and a thermal conductor may be located between the hot part and cool part of the device 100. The thermal wall can shield the cool part from heat, and the thermal conductor may dissipate heat.

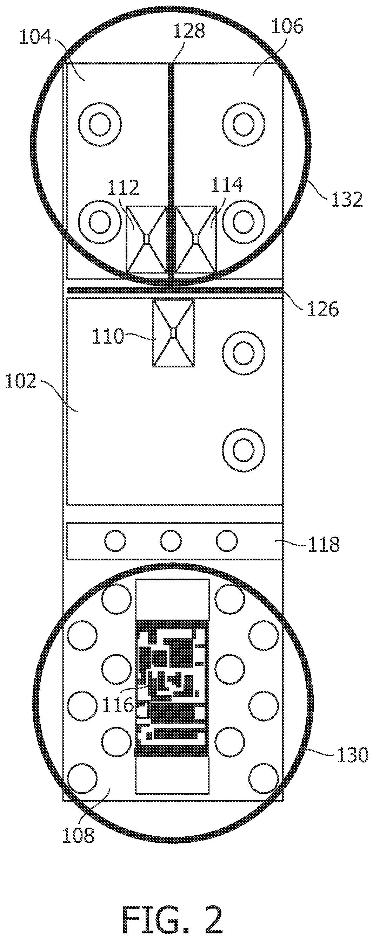

Fig. 2 shows a schematic top view of the exemplary device according to the embodiment as illustrated in Fig. 1. In Fig. 2 a shielding 126 provided between the red LED 110 mounted on the first mounting area 102 and the green and blue LEDs 112, 114 mounted on the second and third mounting areas 104, 106, respectively, is depicted. The shielding 126 may protect the most temperature sensitive LED, i.e. the red LED 110, from heat generated by the less temperature sensitive LEDs, i.e. the green and blue LEDs 112, 114. Thus, a thermal influence of the latter on the former can be reduced. While a shielding spanning both of the green and blue LEDs 112, 114 is depicted in Fig. 2, also other configurations are feasible. For example, a shielding between the red LED 110 and only one of the green and blue LEDs 112, 114 may be provided.

In Fig. 2 also a shielding 128 provided between the green LED 112 mounted on the second mounting area 104 and the blue LED 114 mounted on the third mounting area 106 is depicted. The shielding 128 can reduce a thermal influence of the less temperature sensitive LEDs, i.e. the LEDs 112, 114, on each other. Hence, these LEDs may be thermally decoupled.

Within the material boundary conditions and design rules, it is also possible to design/shape "ring-like" structures for shielding certain parts. Even ring-shaped "dummy" heatsinks might be provided in the device 100. For example, a ring-like structure 130 surrounding the IC 116 can be part of the device 100, as shown in Fig. 2. The ring-like structure 130 may protect the IC 116 from heat generated by the LEDs 110, 112, 114. Further, a ring-like heatsink 132 surrounding the green and blue LEDs 112, 114 can be part of the device 100, as also shown in Fig. 2. The ring-like heatsink 132 may efficiently dissipate heat generated by these less temperature sensitive LEDs 112, 114.

While only the ring-like structure 130 at the IC 116 is depicted in Fig. 2, alternative configurations are conceivable. For example, a ring-like structure surrounding the red LED 110 can be provided. Such ring-like structure may prevent that the red LED 110 suffers from too high temperatures due to heat generated by the green and blue LEDs 112, 114. Further, other kinds of heatsinks than the ring-like heatsink 132 at the green and blue LEDs 112, 114 can be contemplated. For example, a ring-like heatsink surrounding the red LED 110 may be provided. Such ring-like heatsink can efficiently dissipate heat generated by the red LED 110.

Another approach consists in adapting (possibly locally) the structure 124 that surrounds the LEDs 110, 112, 114 and the IC 116, in such a way that the heat transfer is locally increased or decreased. That is, the structure 124 may comprise at least two sections having different heat transfer characteristics. Thus, the heat transfer at a certain location may be locally increased or decreased, in dependence on which component of the device is situated at the location. For example, the structure 124 can be designed such that the heat transfer at the green and blue LEDs 112, 114 is increased. On the other hand, the structure 124 may have a section with low thermal conductivity above a "thermal decoupling pad" such as e.g. the shielding 118. Locally adapting the structure 124 can be useful for LED applications, as the functionality requires that the device or package is open or transparent at the location of the LEDs and that preferably the ICs are shielded from light.

Also for the purpose of heat transfer/shielding improvement the lead frame cross section may be reduced (even locally) by adapting either the lead frame material or by adapting the lead frame fabrication method. That is, the cross section of the device 100 can be reduced at least locally. Hence, a heat dissipation to the outside of the device 100 may be improved.

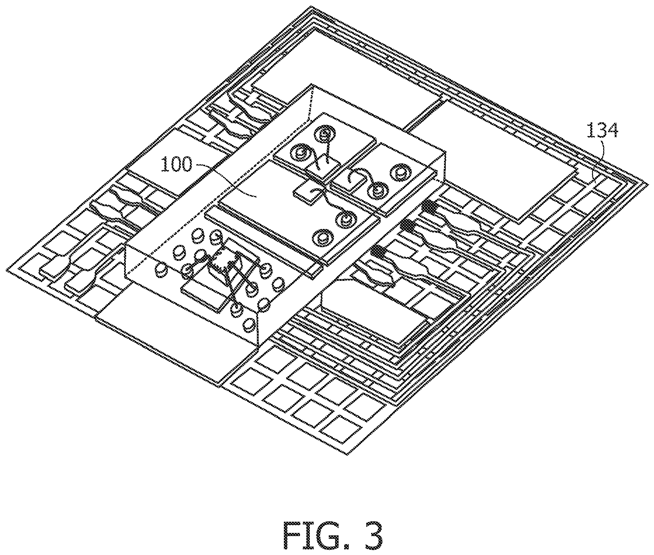

Fig. 3 shows a schematic perspective view of the exemplary device 100 according to the embodiment being mounted on a board 134. The device 100 such as e.g. a LED package can be mounted for example on a ceramic board, a metal core board (that might aid in heat dissipation), a resin board such as e.g. an epoxy board, or some other kind of printed circuit board (PCB). While only one exemplary device 100 is shown in Fig. 3, there may be a plurality of exemplary devices 100 mounted on the board 134.

Connecting a device 100 to the board 134 enables further possibilities for thermal optimization, as the connections transport heat. For example, certain pads on such device 100 can be connected to the board pads, and others may be disconnected (if the functionality allows that). Adapting solder pads on the board 134 can be another approach. Board pads can be equipped with thermal vias to allow even further increased heat transfer. Certain pads of the device 100 may be connected to such board pads that are equipped with thermal vias. By connecting only specific pads of the device 100 and/or using board pads equipped with thermal vias, the heat transfer from the device 100 to the board 134 can be regulated in a desired way. Further, other thermal dissipation enhancing elements may be used in the board 134.

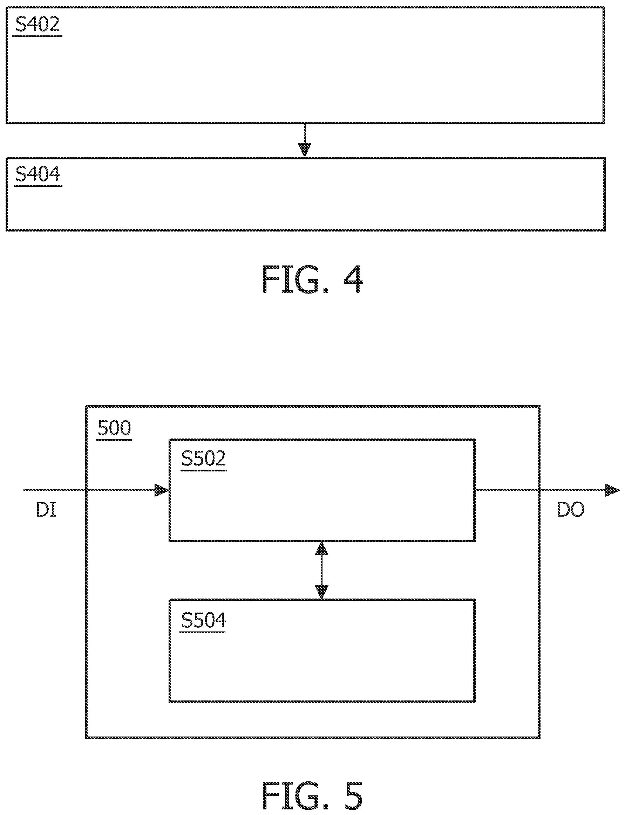

Fig. 4 shows a flowchart illustrating basic steps of an exemplary method according to the embodiment. In a step S402, a plurality of light emitting diodes, respectively configured to emit light of a specific color, can be mounted on at least one mounting area. In a step S404, at least one integrated circuit, configured to drive at least one of the plurality of light emitting diodes, may be mounted on the at least one mounting area, wherein a most temperature sensitive light emitting diode of the plurality of light emitting diodes can be located between less temperature sensitive light emitting diodes of the plurality of light emitting diodes and the at least one integrated circuit.

Fig. 5 shows an example of a software-based implementation of the embodiment. Here, a device 500 can comprise a processing unit (PU) 502, which may be provided on a single chip or a chip module and which can be any processor or computer device with a control unit that performs control based on software routines of a control program stored in a memory (MEM) 504. Program code instructions may be fetched from the MEM 504 and loaded into the control unit of the PU 502 in order to perform processing steps such as those described in connection with Fig. 4. The processing steps can be performed on the basis of input data DI and may generate output data DO. The input data DI may represent e.g. information about locations of components, etc., and the output data DO can represent e.g. instructions for a mounting machine, etc.

As described above, the device 100 may be an UTLP package. That is, it may comply with the design rules of the UTLP packaging technology. The overall width of the device 100 may be e.g. 1.65 mm. The die pad thickness can be 62 µm, and the contact pad thickness may be 25 µm, for example. A minimum distance between pads can be e.g. 100 µm. At the outside of the device 100 an effective heat transfer coefficient of e.g. 15 W/m²K (normal ambient) may occur. If the device 100 is mounted on a board such as e.g. the board 134, an effective heat transfer coefficient at the contacts between the device 100 and the board depends on the configuration of the board. With a simple, not thermally optimized board the effective heat transfer coefficient can be e.g. 200 W/m²K. For a board with relative large copper areas such as e.g. a board with a single copper layer the effective heat transfer coefficient may be 500 W/m²K, for example. With a thermally enhanced board (vias, double layer, etc.) the effective heat transfer coefficient can be e.g. 1000 W/m²K. These parameters are merely examples and are to be considered illustrative and not restrictive.

In summary, the present invention relates to a device, a system, a method and a computer program enabling a thermally improved packaging of a plurality of light emitting diodes and at least one integrated circuit. A most temperature sensitive light emitting diode of the plurality of light emitting diodes is located between less temperature sensitive light emitting diodes of the plurality of light emitting diodes and the at least one integrated circuit. Further, various additional measures such as e.g. varying at least one mounting area of at least one light emitting diode, providing at least one thermal shielding, etc. can be taken in order to thermally optimize the packaging.

While the present invention has been illustrated and described in detail in the drawings and foregoing description, such illustration and description are to be considered illustrative or exemplary and not restrictive. The invention is not limited to the disclosed embodiment.

Variations to the disclosed embodiment can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage.

A computer program capable of controlling a processor to perform the claimed features can be stored/distributed on a suitable medium, such as an optical storage medium or a solid-state medium supplied together with or as part of other hardware, but may also be distributed in other forms, such as via the Internet or other wired or wireless telecommunication systems. It can be used in conjunction with a new system, but may also be applied when updating or upgrading existing systems in order to enable them to perform the claimed features.

A computer program product for a computer can comprise software code portions for performing e.g. processing steps such as those described in connection with Fig. 4 when the computer program product is run on the computer. The computer program product may further comprise a computer-readable medium on which the software code portions are stored, such as e.g. an optical storage medium or a solid-state medium.

Any reference signs in the claims should not be construed as limiting the scope thereof.

## Claims

1. Device comprising:
at least one mounting area (102, 104, 106, 108);
a plurality of light emitting diodes (110, 112, 114) respectively mounted on said at least one mounting area and configured to emit light of a specific color; and
at least one integrated circuit (116) mounted on said at least one mounting area and configured to drive at least one of said plurality of light emitting diodes,
wherein a most temperature sensitive light emitting diode (110) of said plurality of light emitting diodes is located between less temperature sensitive light emitting diodes (112, 114) of said plurality of light emitting diodes and said at least one integrated circuit.

2. Device according to claim 1,
wherein said plurality of light emitting diodes are mounted on at least two different sized mounting areas.

3. Device according to claim 1,
wherein said plurality of light emitting diodes are mounted on at least one mounting area (102, 104, 106) separated from at least one mounting area (108) on which said at least one integrated circuit is mounted.

4. Device according to claim 1, comprising:
at least one thermal shielding (118) located between said plurality of light emitting diodes and said at least one integrated circuit.

5. Device according to claim 1, comprising:
at least one thermal conductor (118) located between said plurality of light emitting diodes and said at least one integrated circuit and configured to transport heat.

6. Device according to claim 1, comprising:
at least one thermal shielding (126) located between said most temperature sensitive light emitting diode and at least one of said less temperature sensitive light emitting diodes.

7. Device according to claim 1, comprising:
at least one thermal shielding (128) located between at least two of said less temperature sensitive light emitting diodes.

8. Device according to claim 1,
wherein at least one of said at least one mounting area is asymmetrically shaped in such a manner that a distance between said plurality of light emitting diodes and said at least one integrated circuit is maximized.

9. Device according to claim 1, comprising:
a structure (124) including at least one material and surrounding said plurality of light emitting diodes and said at least one integrated circuit,
wherein said structure comprises at least two sections having different heat transfer characteristics.

10. Device according to claim 1,
wherein a cross section of said device is reduced at least locally.

11. Device according to claim 1, comprising:
at least one ring-like structure (130) configured to thermally shield at least one of said plurality of light emitting diodes and/or said at least one integrated circuit.

12. Device according to claim 1, comprising:
at least one ring-shaped heatsink (132) configured to dissipate heat emitted by at least one of said plurality of light emitting diodes and/or said at least one integrated circuit.

13. System comprising:
a board (134) including thermal dissipation enhancing elements; and
at least one device according to any one of the preceding claims,
wherein said at least one device is mounted on said board.

14. Method comprising:
mounting a plurality of light emitting diodes, respectively configured to emit light of a specific color, on at least one mounting area (S402); and
mounting at least one integrated circuit, configured to drive at least one of said plurality of light emitting diodes, on said at least one mounting area (S404),
wherein a most temperature sensitive light emitting diode of said plurality of light emitting diodes is located between less temperature sensitive light emitting diodes of said plurality of light emitting diodes and said at least one integrated circuit.

15. Computer program comprising program code means for causing a computer to carry out the steps of a method according to claim 14 when said computer program is carried out on a computer.

## Patentansprüche

1. Vorrichtung umfassend:
mindestens eine Befestigungsfläche (102, 104, 106, 108);
eine Vielzahl von Leuchtdioden (110, 112, 114), die jeweils an der mindestens einen Befestigungsfläche angebracht sind und zum Emittieren von Licht einer bestimmten Farbe konfiguriert sind; und
mindestens eine integrierte Schaltung (116), die an der mindestens einen Befestigungsfläche angebracht ist und konfiguriert ist, mindestens eine der Vielzahl von Leuchtdioden anzusteuern,
wobei eine am meisten temperaturempfindliche Leuchtdiode (110) der Vielzahl von Leuchtdioden sich zwischen weniger temperaturempfindlichen Leuchtdioden (112, 114) der Vielzahl von Leuchtdioden und der mindestens einen integrierten Schaltung befindet.

2. Vorrichtung nach Anspruch 1,
wobei die Vielzahl von Leuchtdioden an mindestens zwei unterschiedlich großen Befestigungsflächen angebracht sind.

3. Vorrichtung nach Anspruch 1,
wobei die Vielzahl von Leuchtdioden an mindestens einer Befestigungsfläche (102, 104, 106) getrennt von mindestens einer Befestigungsfläche (108) angebracht sind, an der die mindestens eine integrierte Schaltung angebracht ist.

4. Vorrichtung nach Anspruch 1, umfassend:
mindestens eine thermische Abschirmung (118), die sich zwischen der Vielzahl von Leuchtdioden und der mindestens einen integrierten Schaltung befindet.

5. Vorrichtung nach Anspruch 1, umfassend:
mindestens einen Wärmeleiter (118), der sich zwischen der Vielzahl von Leuchtdioden und der mindestens einen integrierten Schaltung befindet und zum Transport von Wärme konfiguriert ist.

6. Vorrichtung nach Anspruch 1, umfassend:
mindestens eine thermische Abschirmung (126), die sich zwischen der am meisten temperaturempfindlichen Leuchtdiode und mindestens einem der weniger temperaturempfindlichen Leuchtdioden befindet.

7. Vorrichtung nach Anspruch 1, umfassend:
mindestens eine thermische Abschirmung (128), die sich zwischen mindestens zwei der weniger temperaturempfindlichen Leuchtdioden befindet.

8. Vorrichtung nach Anspruch 1,
wobei mindestens eine der mindestens einen Befestigungsfläche asymmetrisch derart geformt ist, dass ein Abstand zwischen der Vielzahl von Leuchtdioden und der mindestens einen integrierten Schaltung maximiert ist.

9. Vorrichtung nach Anspruch 1, umfassend:
eine Struktur (124), die mindestens ein Material einschließt und die Vielzahl von Leuchtdioden und die mindestens eine integrierte Schaltung umgibt,
wobei die Struktur mindestens zwei Abschnitte mit unterschiedlichen Wärmeübertragungseigenschaften umfasst.

10. Vorrichtung nach Anspruch 1,
wobei ein Querschnitt der Vorrichtung zumindest lokal reduziert ist.

11. Vorrichtung nach Anspruch 1, umfassend:
mindestens eine ringartige Struktur (130), die konfiguriert ist, um mindestens einen der Vielzahl von Leuchtdioden und/oder die mindestens eine integrierte Schaltung thermisch abzuschirmen.

12. Vorrichtung nach Anspruch 1, umfassend:
mindestens einen ringförmigen Kühlkörper (132), der konfiguriert ist, um Wärme abzuleiten, die von mindestens einem der Vielzahl von Leuchtdioden und/oder der mindestens einen integrierten Schaltung emittiert wird.

13. System umfassend:
eine Platte (134), die Wärmeableitungsverstärkungselemente enthält; und
mindestens eine Vorrichtung nach einem der vorstehenden Ansprüche, wobei die mindestens eine Vorrichtung an der Platte angebracht ist.

14. Verfahren umfassend:
Anbringen einer Vielzahl von Leuchtdioden, die jeweils konfiguriert sind, Licht einer bestimmten Farbe zu emittieren, an mindestens einer Befestigungsfläche (S402); und
Anbringen mindestens einer integrierten Schaltung, die zur Ansteuerung mindestens eines der Vielzahl von Leuchtdioden an der mindestens einen Befestigungsfläche (S404) konfiguriert ist,
wobei eine am meisten temperaturempfindliche Leuchtdiode der Vielzahl von Leuchtdioden sich zwischen weniger temperaturempfindlichen Leuchtdioden der Vielzahl von Leuchtdioden und der mindestens einen integrierten Schaltung befindet.

15. Computerprogramm mit Programmcodemitteln, um einen Computer zu veranlassen, die Schritte eines Verfahrens nach Anspruch 14 auszuführen, wenn das Computerprogramm auf einem Computer ausgeführt wird.

## Revendications

1. Dispositif comprenant :
au moins une zone de montage (102, 104, 106, 108) ;
une pluralité de diodes électroluminescentes (110, 112, 114) montées respectivement sur ladite au moins une zone de montage et configurées pour émettre de la lumière d'une couleur spécifique ; et
au moins un circuit intégré (116) monté sur ladite au moins une zone de montage et configuré pour exciter au moins une de ladite pluralité de diodes électroluminescentes,
dans lequel une diode électroluminescente la plus sensible à la température (110) de ladite pluralité de diodes électroluminescentes est située entre les diodes électroluminescentes moins sensibles à la température (112, 114) de ladite pluralité de diodes électroluminescentes et ledit au moins un circuit intégré.

2. Dispositif selon la revendication 1,
dans lequel ladite pluralité de diodes électroluminescentes sont montées sur au moins deux zones de montage de dimension différente.

3. Dispositif selon la revendication 1,
dans lequel ladite pluralité de diode électroluminescentes sont montées sur au moins une zone de montage (102, 104, 106) séparée d'au moins une zone de montage (108) sur laquelle est monté ledit au moins un circuit intégré.

4. Dispositif selon la revendication 1, comprenant :
au moins une protection thermique (118) située entre ladite pluralité de diodes électroluminescentes et ledit au moins un circuit intégré.

5. Dispositif selon la revendication 1, comprenant :
au moins un conducteur thermique (118) situé entre ladite pluralité de diodes électroluminescentes et ledit au moins un circuit intégré et configuré pour transporter de la chaleur.

6. Dispositif selon la revendication 1, comprenant :
au moins une protection thermique (126) située entre ladite diode électroluminescente la plus sensible à la température et au moins une desdites diodes électroluminescentes moins sensibles à la température.

7. Dispositif selon la revendication 1, comprenant :
au moins une protection thermique (128) située entre au moins deux desdites diodes électroluminescentes moins sensibles à la température.

8. Dispositif selon la revendication 1,
dans lequel au moins une de ladite au moins une zone de montage est formée asymétriquement d'une manière telle qu'une distance entre ladite pluralité de diodes électroluminescentes et ledit au moins un circuit intégré est maximisée.

9. Dispositif selon la revendication 1, comprenant :
une structure (124) incluant au moins un matériau et entourant ladite pluralité de diodes électroluminescentes et ledit au moins un circuit intégré,
dans lequel ladite structure comprend au moins deux sections ayant différentes caractéristiques de transfert de chaleur.

10. Dispositif selon la revendication 1,
dans lequel une section transversale dudit dispositif est réduite au moins localement.

11. Dispositif selon la revendication 1, comprenant :
au moins une structure de type anneau (130) configurée pour protéger thermiquement au moins une de ladite pluralité de diodes électroluminescentes et/ou ledit au moins un circuit intégré.

12. Dispositif selon la revendication 1, comprenant :
au moins un puits de chaleur en forme d'anneau (132) configuré pour dissiper la chaleur émise par au moins une de ladite pluralité de diodes électroluminescentes et/ou ledit au moins un circuit intégré.

13. Système comprenant :
une carte (134) incluant des éléments améliorant la dissipation thermique ; et
au moins un dispositif selon l'une quelconque des revendications précédentes,
dans lequel ledit au moins un dispositif est monté sur ladite carte.

14. Procédé comprenant :
le montage d'une pluralité de diodes électroluminescentes, configurées respectivement pour émettre de la lumière d'une couleur spécifique, sur au moins une zone de montage (S402) ; et
le montage d'au moins un circuit intégré, configuré pour exciter au moins une de ladite pluralité de diodes électroluminescentes, sur ladite au moins une zone de montage (S404),
dans lequel une diode électroluminescente la plus sensible à la température de ladite pluralité de diodes électroluminescentes est située entre les diodes électroluminescentes moins sensibles à la température de ladite pluralité de diodes électroluminescentes et ledit au moins un circuit intégré.

15. Programme informatique comprenant des moyens de code de programme pour amener un ordinateur à exécuter les étapes d'un procédé selon la revendication 14 lorsque ledit programme informatique est exécuté sur un ordinateur.
